# EUROPÄISCHE PATENTSCHRIFT

(11) **EP 4 005 359 B1**
(45) Veröffentlichungstag und Bekanntmachung des Hinweises auf die Patenterteilung: **31.07.2024**
(21) Anmeldenummer: 20733966.4
(22) Anmeldetag: 18.06.2020
(51) Int. Cl.: G01R 31/28

(54) **VERFAHREN ZUR ERKENNUNG VON FEHLERN ODER FEHLFUNKTIONEN AN ELEKTRISCHEN ODER ELEKTRONISCHEN BAUTEILEN EINER SCHALTUNGSANORDNUNG**
METHOD FOR DETECTING ERRORS OR MALFUNCTIONS IN ELECTRICAL OR ELECTRONIC COMPONENTS OF A CIRCUIT ARRANGEMENT
PROCÉDÉ DE RECONNAISSANCE DE DÉFAUTS OU DE DÉFAUTS DE FONCTIONNEMENT SUR DES COMPOSANTS ÉLECTRIQUES OU ÉLECTRONIQUES D'UN ARRANGEMENT DE CIRCUIT

(30) Priorität: 24.07.2019 DE 102019120059
(43) Veröffentlichungstag der Anmeldung: 01.06.2022
(73) Patentinhaber: Endress+Hauser SE+Co. KG, 79689 Maulburg (DE)
(72) Erfinder: STRITTMATTER, Christian, 79736 Rickenbach (DE); GERWIG, Simon, 79650 Schopfheim (DE); DÖTSCH, Michael, 79736 Rickenbach (DE)
(74) Vertreter: Koslowski, Christine Adelheid
(86) Internationale Anmeldenummer: PCT/EP2020/066990
(87) Internationale Veröffentlichungsnummer: WO 2021/013445

(56) Entgegenhaltungen:
- EP-A1- 2 830 400
- DE-A1- 102017 222 597

## Beschreibung

Die Erfindung betrifft ein Verfahren zur Erkennung von Fehlern und/oder Fehlfunktionen an elektrischen oder elektronischen Bauteilen einer Schaltungsanordnung. Bevorzugt wird das Verfahren in Verbindung mit der Fertigung von Schaltungsanordnungen verwendet, die in Feldgeräten der Automatisierungstechnik eingesetzt werden.

In der Prozessautomatisierung ebenso wie in der Fertigungsautomatisierung werden vielfach Feldgeräte zur Erfassung und/oder Beeinflussung von physikalischen, chemischen oder biologischen Prozessgrößen eingesetzt. Zur Erfassung der Prozessgrößen dienen Messgeräte. Diese werden beispielsweise zur Druck- und Temperaturmessung, Leitfähigkeitsmessung, Durchflussmessung, pH-Messung, Füllstandmessung, etc. verwendet und erfassen die entsprechenden Prozessvariablen Druck, Temperatur, Leitfähigkeit, pH-Wert, Füllstand, Durchfluss etc. Zur Beeinflussung der Prozessgrößen werden Aktorsysteme verwendet. Beispiele für Aktoren sind Pumpen oder Ventile, die den Durchfluss einer Flüssigkeit in einem Rohr oder den Füllstand in einem Behälter beeinflussen können. Neben den zuvor genannten Messgeräten und Aktoren werden unter Feldgeräten auch Remote I/Os, Funkadapter bzw. allgemein Geräte verstanden, die auf der Feldebene angeordnet sind. Als Feldgeräte werden allgemein gesprochen Geräte bezeichnet, die in der Nähe des Prozesses oder der Anlage eingesetzt werden und die prozess- oder anlagerelevante Informationen liefern oder verarbeiten.

Um Feldgeräte der Automatisierungstechnik auch in explosionsgefährdeten Bereichen (Gas und/oder Staub) einsetzen zu können, müssen die elektrischen oder elektronischen Bauteile der Schaltungsanordnungen der Feldgeräte in der geeigneten Ex-Zündschutzart ausgelegt sein. Insbesondere gilt dies für die Bauteile, die der analogen Signalaufbereitung dienen. Es muss sichergestellt sein, dass die Energiezufuhr stets soweit begrenzt wird, dass jegliche Funkenbildung -auch im Fehlerfall- effektiv vermieden wird. Dies wird durch den Einsatz von spannungs- und strombegrenzenden Bauteilen sichergestellt. Um die erforderlichen Zulassungen zu erhalten, sind weiterhin Kapazitäten, welche an den Anschlussklemmen vorhanden sind, anzugeben und zu begrenzen.

Um sicherzustellen, dass die für die Begrenzungsmaßnahmen vorgesehenen elektrischen oder elektronischen Bauteile wirksam sind, werden diese üblicherweise mehrfach ausgeführt. Um die notwendigen Zulassungen zu erhalten, muss darüber hinaus durch Stückprüfung nachgewiesen werden, dass die verwendeten Bauteile tatsächlich die Werte aufweisen, die in den Zulassungsunterlagen spezifiziert sind. Hierzu erfolgt im Rahmen der Fertigung eine PPVS Prüfung (Present, Polarity, Value, Solder). Es wird also überprüft: Sind die korrekten Bauteile vorhanden? Ist die Polarität der Bauteile korrekt? Haben die Bauteile die richtigen Werte? Sind die Bauteile korrekt gelötet?

Diese sog. Prüfabdeckung wird üblicherweise über eine AOI (Automatische Optische Inspektion) erlangt, welche die Anwesenheit der korrekten Bauteile und deren korrekte Lötung sicherstellt. Sind die Lötstellen mit der AOI nicht sichtbar, so kommt eine AOI in Verbindung mit einer AXI (Automatische Röntgen-Inspektion) zum Einsatz. Als zusätzliche Prüfabdeckung ist ein elektrischer Funktionstest (z.B. ein In-Circuit-Test - ICT) erforderlich, über welchen die korrekte Polung (sofern eine vorhanden ist) und der korrekte Wert (Spannung, Strom, Widerstand) eines jeden Bauteils sichergestellt wird. Um den elektrischen Funktionstest durchzuführen, sind an jedem der Bauteile Testpunkte vorzusehen.

Nachteil dieser Testpunkte ist ein Platzverlust für Schaltungsbauteile auf der Leiterplatte: Aufgrund des Platzbedarfs für die Testpunkte ist die verfügbare Fläche für die Anordnung von Bauteilen und Leiterbahnen sowie für evtl. benötigte Abstandsbereiche eingeschränkt. Im Ergebnis kann dies bewirken, dass eine Schaltungsanordnung nur wegen der benötigten Testpunkte nicht in einem gewünschten Formfaktor realisierbar ist.

Die Patentdokumente DE 10 2017 222597 A1 und EP 2 830 400 A1 offenbaren jeweils ein Verfahren zur Erkennung von Fehlern oder Fehlfunktionen an elektrischen Bauteilen von gleich aufgebauten Schaltungsanordnungen, wobei sich jede der Schaltungsanordnungen auf einer Leiterplatte befindet und wobei mehrere Leiterplatten mit jeweils einer gleich aufgebauten Schaltungsanordnung aneinander angrenzend auf einem Leiterplattennutzen vorgesehen sind. Die offenbarten Verfahren bestücken die Leiterplatten des Leiterplattennutzens mit elektrischen Bauteilen entsprechend der Schaltungsanordnung. Von einem für den Aufbau der Schaltungsanordnungen verwendeten analogen elektrischen Bauteil wird ein entsprechendes Prüfbauteil in einem Randbereich des Leiterplattennutzens bestückt. Das Prüfbauteil wird mit Testpunkten versehen und der korrekte Funktionswert des Prüfbauteils wird überprüft. EP 2 830 400 A1 offenbart zusätzlich, dass das in dem Randbereich des Leiterplattennutzens bestückte elektrische Prüfbauteil von der gleichen Charge beziehungsweise von der gleichen Bauteile-Rolle wie das für den Aufbau der Schaltungsanordnungen verwendete analoge elektrische Bauteil stammt.

Aufgabe der Erfindung ist es, ein Verfahren zur Erkennung von Fehlern oder Fehlfunktionen an elektrischen oder elektronischen Bauteilen einer Schaltungsanordnung anzugeben, das einfach und zuverlässig durchführbar ist.

Die Aufgabe wird gelöst durch ein Verfahren zur Erkennung von Fehlern oder Fehlfunktionen an elektrischen oder elektronischen Bauteilen von gleich aufgebauten Schaltungsanordnungen gemäß des unabhängigen Anspruchs 1, wobei sich jede der Schaltungsanordnungen auf einer Leiterplatte befindet und wobei mehrere Leiterplatten mit jeweils einer gleich aufgebauten Schaltungsanordnung aneinander angrenzend auf einem Leiterplattennutzen vorgesehen sind, wobei das Verfahren die folgenden Verfahrensschritte aufweist:
Jede der Leiterplatten des Leiterplattennutzens wird mit elektrischen oder elektronischen Bauteilen entsprechend der Schaltungsanordnung bestückt;
Von jedem der für den Aufbau der Schaltungsanordnungen verwendeten analogen elektrischen oder elektronischen Bauteile wird jeweils ein entsprechendes Prüfbauteil in einem Randbereich des Leiterplattennutzens bestückt;
Die in den Randbereich des Leiterplattennutzens bestückten analogen elektrischen oder elektronischen Prüfbauteile werden mit Testpunkten versehen;
Der korrekte Funktionswert und/oder die korrekte Polung der mit Testpunkten versehenen und sich im Randbereich des Leiterplattennutzens befindlichen analogen elektrischen oder elektronischen Prüfbauteile werden/wird überprüft.

Bevorzugt ist die Schaltungsanordnung so ausgestaltet, dass sie insbesondere als Sensor- oder Aktorelektronik oder als Umformerelektronik für ein Feldgerät der Automatisierungstechnik verwendbar ist.

Gemäß des erfindungsgemäßen Verfahrens wird sichergestellt, dass die in den Randbereich des Leiterplattennutzens bestückten unterschiedlichen elektrischen oder elektronischen Prüfbauteile jeweils von der gleichen Charge bzw. von der gleichen Bauteile-Rolle stammen, wie die entsprechenden auf den Leiterplatten für die Schaltungsanordnungen verwendeten elektrischen oder elektronischen Bauteile. Daher ist vorgesehen, dass die elektrischen oder elektronischen Prüfbauteile im Randbereich des Leiterplattennutzens bestückt werden, nachdem die Leiterplatten mit den elektrischen oder elektronischen Bauteilen der Schaltungsanordnung vollständig bestückt worden sind. Hierdurch lassen sich insbesondere auch Anspleißfehler während des Fertigungsprozesses der Leiterplattennutzen ausschließen. Ein Anspleißfehler könnte beispielsweise dadurch auftreten, dass fehlerhaft eine Bauteile-Rolle mit zweiten Bauteilen an eine Bauteile-Rolle mit ersten Bauteilen angeschlossen wird, wobei die zweiten Bauteile von den ersten Bauteilen verschieden sind.

Eine vorteilhafte Weiterbildung des erfindungsgemäßen Verfahrens sieht vor, dass als elektrischer Test zur Überprüfung der unterschiedlichen Prüfbauteile ein geeigneter Test verwendet wird. Bei dem elektrischen Test wird überprüft, ob jedes der verwendeten elektrischen oder elektronischen Bauteile auf dem Nutzenrand den spezifizierten Wert hat und ob die Bauteile korrekt gepolt sind.

Neben der Überprüfung des korrekten Wertes und ggf. der korrekten Polung der elektrischen oder elektronischen Bauteile erfolgt gemäß einer Weiterbildung des erfindungsgemäßen Verfahrens eine optische Inspektion der auf dem Leiterplattennutzen angeordneten elektrischen oder elektronischen Bauteile und der entsprechenden Prüfbauteile. Verwendet wird z.B. eine Automatische Optische Inspektion (AOI) oder ein anderes bekanntes Verfahren. Insbesondere wird hierbei überprüft, ob die erforderlichen elektrischen oder elektronischen Bauteile ebenso wie die entsprechenden Prüfbauteile vorhanden sind und ob deren Lötung korrekt durchgeführt ist. Bevorzugt werden bei der Prüfung also zwei unterschiedliche Tests durchgeführt: Einerseits wird ein elektrisches Testverfahren durchgeführt, um die korrekte Funktion der elektrischen oder elektronischen Bauteile zu überprüfen. Andererseits kommt ein optisches Testverfahren wie MOI, AOI und Röntgen zur Anwendung. Mittels dieses Verfahrens wird die Verarbeitungsqualität beurteilt und überprüft.

In Verbindung mit der Erfindung wird die optische Überprüfung auf dem Leiterplattennutzen durchgeführt; hingegen genügt es, wenn der elektrische Test nur bei den auf dem Nutzenrand angeordneten Prüfbauteilen durchgeführt wird. Bei diesen Prüfbauteile handelt es sich insbesondere um Bauteile, die für die Einhaltung der Ex-Sicherheitsanforderungen von Feldgeräten in der Automatisierungstechnik relevant sind. Es kann sich beispielsweise um Widerstände, Z-Dioden, Kondensatoren, usw. handeln. Bevorzugt werden als Prüfbauteile somit elektrische oder elektronische Bauteile ausgewählt und auf dem Nutzenrand platziert, die den sicheren Einsatz im explosionsgefährdeten Bereich garantieren. Nur an diesen elektrischen oder elektronischen Prüfbauteilen für den explosionsgefährdeten Bereich, die sich im Randbereich des Leiterplattennutzens befinden, wird der elektrische Test durchgeführt. Bei dem elektrischen Test werden der Wert und ggf. die Polarität der Prüfbauteile getestet. Da die Prüfbauteile elektrisch von anderweitigen Komponenten entkoppelt sind, ist die Überprüfung einfacher und besser/sicherer durchzuführen. Die bislang erforderliche Überprüfung mittels eines ICT Testers entfällt. Dies bedeutet natürlich auch eine erhebliche Kosten- und Zeiteinsparung.

Die Erfindung hat zusammengefasst also gleich mehrere Vorteile:
a) Reduktion des Platzbedarfs insbesondere bei Ex-Baugruppen/Bauteilen bei unveränderter Prüfabdeckung: Mit der erfindungsgemäßen Lösung und Ihren Ausgestaltungen kann eine erhebliche Anzahl von Testpunkten auf den Leiterplatten eingespart werden. Testpunkte haben nun nur noch die elektrisch zu testenden und auf dem Nutzenrand bestückten Bauteile, bei denen es sich bevorzugt um analoge Bauteile handelt, die der Sicherstellung des Explosionsschutzes dienen. Durch den gewonnenen Platz auf der Leiterplatte kann die Leiterplatte verkleinert werden, was die Fertigungskosten reduziert und dem Wunsch nach Miniaturisierung der Leiterplatten entgegenkommt. Alternativ kann auf derselben Fläche eine größere Anzahl von Bauteilen aufgebracht werden.
b) Reduktion des Prüfaufwands: Die Prüfabdeckung hinsichtlich des Vorhandenseins und korrekten Lötung eines jeden einzelnen Bauteils auf dem Leiterplattennutzen erfolgt beispielsweise über eine AOI Prüfung. Diese Überprüfung erfolgt üblicherweise nach dem Bestücken der Leiterplatten über ein optisches Verfahren. Der korrekte Wert und ggf. die korrekte Polung der Bauteile auf dem Nutzenrand wird indirekt über eine Bauteilemessung bestimmt. Erfindungsgemäß ist die Anzahl der zu messenden Bauteile somit erheblich verringert, da nur die Prüfbauteile auf dem Nutzenrand überprüft werden. Hierbei ist es natürlich auch von Vorteil, dass ein zu einem Prüfbauteil korrespondierender Bauteiletyp mehrfach auf dem Leiterplattennutzen vorkommt, aber nur einmal pro Leiterplattennutzen einer Überprüfung unterzogen werden muss.
c) Senkung der Fertigungskosten: Die Prüfzeit - die üblicherweise eine aufwändiger und somit teurer Verfahrensschritt ist - wird erheblich verringert.

Damit das Verfahren zuverlässig funktioniert, muss sichergestellt werden, dass die zu testenden Bauteile auf dem Nutzenrand von der gleichen Materialrolle stammen, wie die entsprechenden Bauteile der Schaltungsanordnung auf dem Leiterplattennutzen. Daher werden die Prüfbauteile im Randbereich aufgebracht, wenn die Bauteile bereits auf dem entsprechenden Leiterplattennutzen bestückt sind.

Die Erfindung wird anhand der nachfolgenden Figuren näher erläutert. Es zeigt:
Fig. 1: eine schematische Darstellung eines Leiterplattennutzens mit mehreren Leiterplatten, der eine aus dem Stand der Technik bekannte Lösung verdeutlicht, und
Fig. 2: eine schematische Darstellung eines Leiterplattennutzens mit mehreren Leiterplatten, der das erfindungsgemäße Verfahren verdeutlicht.

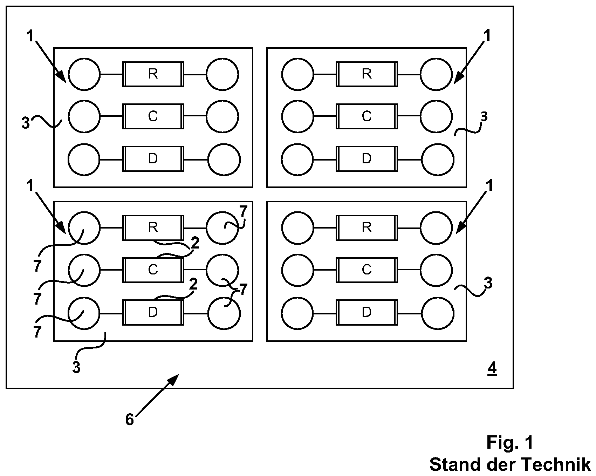

Fig. 1 zeigt eine schematische Darstellung eines Leiterplattennutzens 4 mit mehreren Leiterplatten 3, der ein aus dem Stand der Technik bekanntes Verfahren verdeutlicht. Auf jeder der Leiterplatten 3 des Leiterplattennutzens 4 ist die gleiche Schaltungsanordnung 1 realisiert. Bei den Schaltungsanordnungen 1 handelt es sich beispielsweise um eine Schaltung zur analogen Signalaufbereitung eines Feldgeräts der Automatisierungstechnik. Diese Schaltungsanordnung 1 ist bevorzugt so ausgelegt, dass sie den Anforderungen für den Einsatz in einem explosionsgefährdeten Bereich genügt.

Gezeigt sind von den Schaltungsanordnungen 1 zur Verdeutlichung des Unterschiedes zwischen dem Stand der Technik und der erfindungsgemäßen Lösung lediglich drei analoge Bauteile 2. Diese sind üblicherweise Bestandteile einer jeden Schaltungsanordnung 1, die im explosionsgefährdeten Bereich eingesetzt wird: ein Widerstand R, ein Kondensator C und eine Diode D.

Um nach Beendigung der Bestückung des Leiterplattennutzens 4 garantieren zu können, dass die Bauteile 2 den korrekten Wert haben und dass der Kondensator C und die Diode D die korrekte Polung aufweisen, wird ein elektrischer Funktionstest ausgeführt. Dieser elektrische Funktionstest kann mit einem Multimeter erfolgen oder mit einem eigens für die Schaltungsanordnung 1 gefertigten Tester. Damit der Test durchgeführt werden kann, muss jedes der Bauteile 2 der Leiterkarten 3 zwei Testpunkte 7 aufweisen. Wie bereits zuvor beschrieben, benötigen die Testpunkte 7 Platz auf den Leiterplatten 3. Die Nachteile wurden bereits zuvor beschrieben.

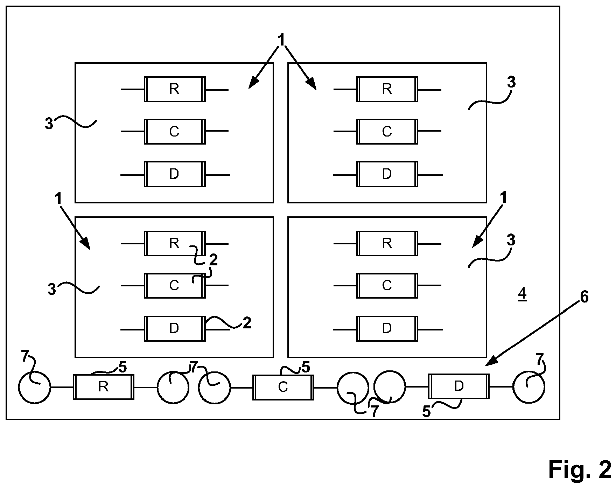

Fig. 2 zeigt eine schematische Darstellung des in Fig. 1 beschriebenen Leiterplattennutzens 4 mit mehreren Leiterplatten 3, die das erfindungsgemäße Verfahren verdeutlichen. Der Aufbau der auf den Leiterplatten 3 des Leiterplattennutzens 4 angeordneten Schaltungsanordnungen 1 entspricht dem in Fig. 1 gezeigten Aufbau. Die Bauteile 2 der Schaltungsanordnungen 1 werden übrigens üblicherweise nach der Bestückung direkt auf die Oberfläche der Leiterplatten 3 gelötet.

Die auf den Leiterplatten 3 angeordneten Bauteile 2 haben keine Testpunkte 7. Dafür sind in einem der Randbereiche 6 des Leiterplattennutzens 4 Prüfbauteile 5 vorgesehen. Diese werden bestückt, nachdem die Bauteile 2 auf den Leiterplatten 3 des Leiterplattennutzens 4 bestückt sind - also am Ende des Bestückungsverfahrens des Leiterplattennutzens 4. Hierdurch wird sichergestellt, dass die Prüfbauteile von der derselben Bauteile-Rolle stammen wie die Bauteile 2 auf dem entsprechenden Leiterplattennutzen 4. Wurde während des Bestücken des Leiterplattennutzens 4 eine neue Bauteile-Rolle angespleißt, so wird durch das Bestücken der Prüfbauteile am Nutzenrand, das nach dem Bestücken des Leiterplattennutzens erfolgt, sichergestellt, dass die angespleißte Bauteile-Rolle die korrekten Bauteile enthält. Die leer gewordene Materialrolle wurde ja bereits bei den vorhergehenden Leiterplattennutzen überprüft. Bei der erfindungsgemäßen Lösung erfolgt nun der elektrische Test (automatisch, halbautomatisch oder manuell) lediglich an den Prüfbauteilen 5. Zeigt jedes der Prüfbauteile 5 den korrekten Wert und ggf. die korrekte Polung, so hat auch jedes der entsprechenden Bauteile 2 auf dem Leiterplattennutzen 4 den korrekten Wert und ggf. die korrekte Polung.

Erfindungsgemäß ist es somit möglich, die Überprüfung der Bauteile 2 eines Leiterplattennutzens 4 mittels einer reduzierten Anzahl von Prüfbauteilen 5 so durchzuführen, dass die vorgeschriebenen Sicherheitsanforderungen 1 für den Einsatz der Schaltungsanordnungen 1 im explosionsgefährdeten Bereich erfüllt sind.

Zusätzlich zu dem zuvor beschriebenen Test werden die Leiterplattennutzen 4 mit den Schaltungsanordnungen 1 üblicherweise noch einer optischen Inspektion unterzogen. Hier wird festgestellt, ob alle Bauteile 2 bzw. Prüfbauteile 5, die vorhanden sein sollen, auch tatsächlich vorhanden sind, und ob deren Verlötung bzw. Befestigung auf den Leiterkarten 3 korrekt erfolgt ist.

### Bezugszeichenliste

- 1: Schaltungsanordnung
- 2: elektrisches/elektronisches Bauteil
- 3: Leiterplatte
- 4: Leiterplattennutzen
- 5: Prüfbauteil
- 6: Randbereich
- 7: Testpunkt

## Patentansprüche

1. Verfahren zur Erkennung von Fehlern oder Fehlfunktionen an elektrischen oder elektronischen Bauteilen (3) von gleich aufgebauten Schaltungsanordnungen (1), wobei sich jede der Schaltungsanordnungen (1) auf einer Leiterplatte befindet und wobei mehrere Leiterplatten (3) mit jeweils einer gleich aufgebauten Schaltungsanordnung (1) aneinander angrenzend auf einem Leiterplattennutzen (4) vorgesehen sind, wobei das Verfahren die folgenden Verfahrensschritte aufweist:
Jede der Leiterplatten (3) des Leiterplattennutzens (4) wird mit elektrischen oder elektronischen Bauteilen (2) entsprechend der Schaltungsanordnung (1) bestückt;
Von für den Aufbau der Schaltungsanordnungen (1) verwendeten analogen elektrischen oder elektronischen Bauteile (2) wird jeweils ein entsprechendes Prüfbauteil (5) in einem Randbereich (6) des Leiterplattennutzens (4) bestückt, wobei sichergestellt wird, dass die in den Randbereich (6) des Leiterplattennutzens (4) bestückten unterschiedlichen elektrischen oder elektronischen Prüfbauteile (5) jeweils von der gleichen Charge bzw. von der gleichen Bauteile-Rolle stammen, wie die entsprechenden auf den Leiterplatten (3) für die Schaltungsanordnungen (1) verwendeten elektrischen oder elektronischen Bauteile (2);
Die in den Randbereich (6) des Leiterplattennutzens (4) bestückten analogen elektrischen oder elektronischen Prüfbauteile (5) werden mit Testpunkten (7) versehen;
Der korrekte Funktionswert und/oder die korrekte Polung der mit Testpunkten (7) versehenen und sich im Randbereich (6) des Leiterplattennutzens (4) befindlichen analogen elektrischen oder elektronischen Prüfbauteile (5) werden/wird überprüft, **dadurch gekennzeichnet, dass**:
Von jedem der für den Aufbau der Schaltungsanordnungen (1) verwendeten analogen elektrischen oder elektronischen Bauteile (2) jeweils ein entsprechendes Prüfbauteil (5) in einem Randbereich (6) des Leiterplattennutzens (4) bestückt wird, wobei die elektrischen oder elektronischen Prüfbauteile (5) im Randbereich (6) des Leiterplattennutzens (4) bestückt werden, nachdem die Leiterplatten (3) mit den elektrischen oder elektronischen Bauteilen (2) der Schaltungsanordnung (1) vollständig bestückt worden sind.

2. Verfahren nach Anspruch 1,
wobei als elektrischer Test zur Überprüfung der unterschiedlichen Prüfbauteile (5) ein geeigneter Test, beispielsweise ein In-Circuit-Test, verwendet wird.

3. Verfahren nach einem oder mehreren der vorhergehenden Ansprüche, wobei eine optische Inspektion der auf dem Leiterplattennutzen (4) angeordneten elektrischen oder elektronischen Bauteile (2) und der entsprechenden Prüfbauteile (5) mittels einer Automatischen Optischen Inspektion (AOI) erfolgt, wobei insbesondere überprüft wird, ob die erforderlichen elektrischen oder elektronischen Bauteile (2) ebenso wie die entsprechenden Prüfbauteile (5) vorhanden sind und ob deren Lötung korrekt durchgeführt ist.

4. Verfahren nach einem oder mehreren der vorhergehenden Ansprüche, wobei bevorzugt als Prüfbauteile (5) elektrische oder elektronische Bauteile (2) ausgewählt werden, die für den explosionsgefährdeten Bereich ausgelegt sind, und
wobei an den elektrischen oder elektronischen Prüfbauteilen (5) für den explosionsgefährdeten Bereich, die sich im Randbereich (6) des Leiterplattennutzens (4) befinden, der elektrische Test durchgeführt wird.

5. Verfahren nach einem oder mehreren der vorhergehenden Ansprüche, wobei die Schaltungsanordnung (1) so ausgestaltet wird, dass sie insbesondere als Sensor- oder Aktorelektronik oder als Umformerelektronik für ein Feldgerät der Automatisierungstechnik verwendbar ist.

## Claims

1. A method for detecting faults or malfunctions in electrical or electronic components (3) with identical circuit configurations (1), wherein each of the circuit configurations (1) is located on a PCB and wherein multiple PCBs (3) each with an identical circuit configuration (1) are placed adjacent to each other on a PCB panel (4), wherein the method includes the following process steps:
Each one of the PCBs (3) on the PCB panel (4) is equipped with electrical or electronic components (2) according to the circuit configuration (1);
An edge area (6) of the PCB panel (4) is equipped with a corresponding test component (5) of each of the analog electrical or electronic components (2) used to set up the circuit configurations (1), wherein it is ensured that each of the different electrical or electronic test components (5) fitted in the edge area (6) of the PCB panel (4) come from the same batch or the same component reel as the corresponding electrical or electronic components (2) used on the PCBs (3) for the circuit configurations (1);
The analog electrical or electronic test components (5) fitted in the edge area (6) of the PCB panel (4) have test points (7);
The correct functional value and/or the correct polarity of the analog electrical or electronic test components (5) which have test points (7) and are located in the edge area (6) of the PCB panel (4) is/are tested, **characterized in that**:
An edge area (6) of the PCB panel (4) is equipped with a corresponding test component (5) of each of the analog electrical or electronic components (2) used to set up the circuit configurations (1), wherein the edge area (6) of the PCB panel (4) is equipped with the electrical or electronic test components (5) after the PCBs (3) have been fully equipped with the electrical or electronic components (2) of the circuit configuration (1).

2. The method as claimed in claim 1,
wherein a suitable test, such as an in-circuit test, is used as an electrical test for testing the different test components (5).

3. The method as claimed in one or more of the preceding claims, wherein an optical inspection of the electrical or electronic components (2) arranged on the PCB panel (4) and the corresponding test components (5) is performed by means of an automated optical inspection (AOI), wherein the inspection focuses in particular on whether the required electrical or electronic components (2) and the corresponding test components (5) are present and whether they have been soldered correctly.

4. The method as claimed in one or more of the preceding claims, wherein electrical or electronic components (2) designed for the hazardous area are preferably used as test components (5), and
wherein the electrical test is performed on the electrical or electronic test components (5) for the hazardous area which are located in the edge area (6) of the PCB panel (4).

5. The method as claimed in one or more of the preceding claims, wherein the circuit configuration (1) is designed so that it can be used, in particular, as a sensor or actuator electronic assembly or as a converter electronic assembly for an automation technology field device.

## Revendications

1. Procédé destiné à la détection d'erreurs ou de dysfonctionnements sur des composants électriques ou électroniques (3) d'arrangements de circuits (1) de même structure, chacun des arrangements de circuits (1) se trouvant sur une carte de circuit imprimé et plusieurs cartes de circuit imprimé (3), lesquelles comportent chacune un arrangement de circuits (1) de même structure, étant prévues de manière adjacente les unes aux autres sur un flanc de circuits imprimés (4), lequel procédé comporte les étapes suivantes :
Chacune des cartes de circuits imprimés (3) du flanc de circuits imprimés (4) est équipée de composants électriques ou électroniques (2) selon l'arrangement de circuits (1) ;
Un composant de contrôle (5) correspondant à chacun des composants électriques ou électroniques analogiques (2) utilisés pour la constitution des arrangements de circuits (1) est placé dans une zone marginale (6) du flanc de circuits imprimés (4), en s'assurant que les différents composants de contrôle électriques ou électroniques (5) montés dans la zone marginale (6) du flanc de circuits imprimés (4) proviennent respectivement du même lot ou du même rouleau de composants que les composants électriques ou électroniques (2) correspondants utilisés sur les cartes de circuits imprimés (3) pour les arrangements de circuits (1) ;
Les composants de contrôle électriques ou électroniques analogiques (5) montés dans la zone marginale (6) du flanc de circuits imprimés (4) sont pourvus de points de test (7) ;
La valeur fonctionnelle correcte et/ou la polarité correcte des composants de contrôle électriques ou électroniques analogiques (5) pourvus de points de test (7) et se trouvant dans la zone marginale (6) du flanc de circuits imprimés (4) est/sont vérifiée(s),
**caractérisé en ce que**
parmi chacun des composants électriques ou électroniques analogiques (2) utilisés pour la constitution des arrangements de circuit (1), un composant de contrôle (5) correspondant est respectivement équipé dans une zone marginale (6) du flanc de circuits imprimés (4), les composants de contrôle électriques ou électroniques (5) étant équipés dans la zone marginale (6) du flanc de circuits imprimés (4) après que les cartes de circuit imprimé (3) aient été entièrement équipées des composants électriques ou électroniques (2) de l'arrangement de circuit (1).

2. Procédé selon la revendication 1,
pour lequel un test approprié, par exemple un test en circuit, est utilisé comme test électrique pour vérifier les différents composants de contrôle (5).

3. Procédé selon l'une ou plusieurs des revendications précédentes,
pour lequel une inspection optique des composants électriques ou électroniques (2) disposés sur le flanc de circuits imprimés (4) et des composants de contrôle (5) correspondants est effectuée au moyen d'une inspection optique automatique (AOI) où l'on vérifie notamment si les composants électriques ou électroniques (2) nécessaires sont présents, ainsi que les composants de contrôle (5) correspondants, et si leur soudage est effectué correctement.

4. Procédé selon l'une ou plusieurs des revendications précédentes,
pour lequel on choisit de préférence comme composants de contrôle (5) des composants électriques ou électroniques (2), lesquels sont conçus pour la zone explosible, et
pour lequel on effectue le test électrique sur les composants de contrôle électriques ou électroniques (5) pour la zone explosible, lesquels composants se trouvent dans la zone marginale (6) du flan de circuits imprimés (4).

5. Procédé selon l'une ou plusieurs des revendications précédentes,
pour lequel l'arrangement de circuits (1) est conçu de manière à pouvoir être utilisé notamment comme électronique de capteur ou d'actionneur ou comme électronique de transmetteur pour un appareil de terrain de la technique d'automatisation.
